Europäisches Patentamt

European Patent Office

Office européen des brevets

(19)

(11) Veröffentlichungsnummer: **0 013 710**
**B1**

(12)
# EUROPÄISCHE PATENTSCHRIFT

(45) Veröffentlichungstag der Patentschrift:
**10.10.84**

(21) Anmeldenummer: **79104715.2**

(22) Anmeldetag: **27.11.79**

(51) Int. Cl.³: **H 03 K 5/02,** H 03 K 17/08,
H 03 K 17/04, G 11 C 11/40

(54) **Gegentakt-Treiberschaltung, deren Ausgang direkt mit den Ausgängen weiterer Treiberschaltungen verknüpfbar ist.**

(30) Priorität: **29.12.78 US 974637**

(43) Veröffentlichungstag der Anmeldung:
**06.08.80 Patentblatt 80/16**

(45) Bekanntmachung des Hinweises auf die Patenterteilung:
**10.10.84 Patentblatt 84/41**

(84) Benannte Vertragsstaaten:
**DE FR GB**

(56) Entgegenhaltungen:
**DE - B - 1 299 703**
**US - A - 3 531 660**

**IBM TECHNICAL DISCLOSURE BULLETIN, Band 16, Nr. 12, Mai 1974, New York, US G.J. GAUDENZI: "Quad-state output driver", Seiten 3929-3930**
**IBM TECHNICAL DISCLOSURE BULLETIN, Band 18, Nr. 10, März 1976, New York, US, S.D. MALAVIYA: "Self-protected totem pole driver", Seiten 3236-3627**
**IBM TECHNICAL DISCLOSURE BULLETIN, Band 18, Nr. 11, April 1976, New York, US, W.S. KLARA et al.: "Transient push-pull driver", Seite 3651**
**IBM TECHNICAL DISCLOSURE BULLETIN, Band 22, Nr. 1, Juni 1979, New York, US, E.F. CULICAN et al.: "High performance open collector driver", Seiten 144-145**
**IBM TECHNICAL DISCLOSURE BULLETIN, Band 22, Nr.**

(73) Patentinhaber: **International Business Machines Corporation, Old Orchard Road, Armonk, N.Y. 10504 (US)**

(72) Erfinder: **Gaudenzi, Gene Joseph, Oak Ridge Road, Purdys, New York 10578 (US)**

(74) Vertreter: **Gaugel, Heinz, Dipl.-Ing., Schönaicher Strasse 220, D-7030 Böblingen (DE)**

(56) Entgegenhaltungen: (Fortsetzung)
**2, Juli 1979, New York, US, G.J. GAUDENZI: "Module-in-place test driver circuit", Seite 606**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft eine Gegentakt-Treiberschaltung, die mit entsprechenden weiteren Treiberschaltungen durch direkte elektrische Verbindung der Ausgänge logisch verknüpfbar ist und hohe Schaltgeschwindigkeiten zuläßt.

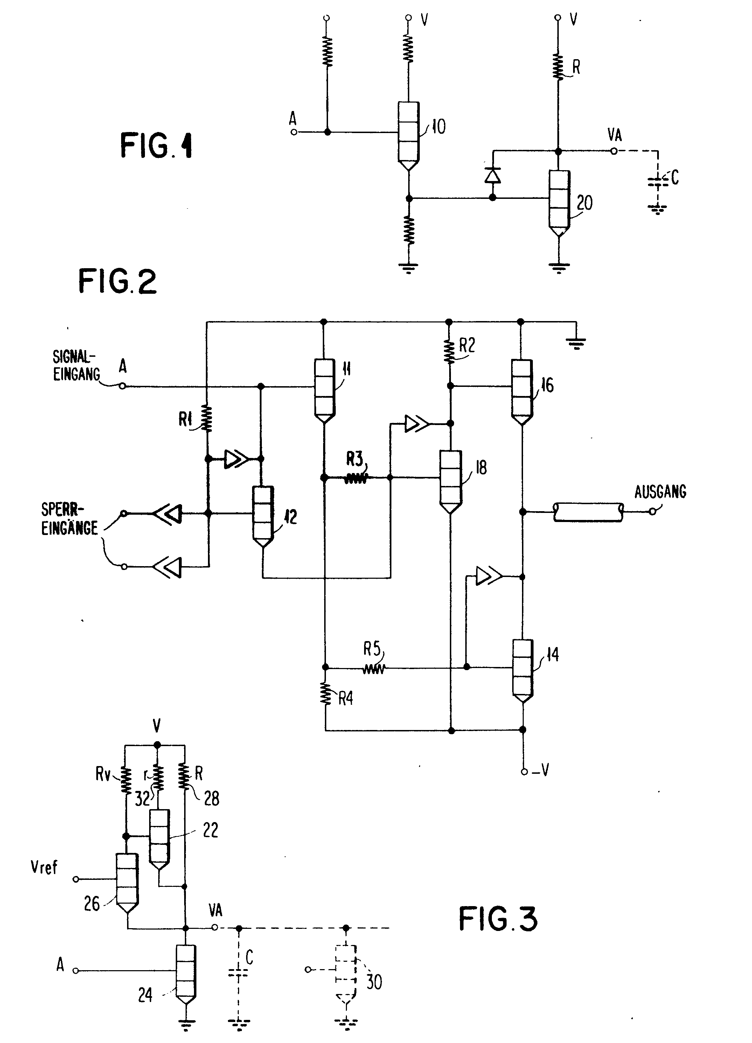

In der modernen Technik gewinnt das Streben nach hoher Arbeitsgeschwindigkeit der Systeme ständig an Bedeutung. Dies gilt insbesondere für digitale Halbleiterschaltungen, bei denen die Schaltgeschwindigkeit höchste Bedeutung erlangt hat. Bei komplexen digitalen Systemen besteht außerdem häufig die Forderung, daß eine Vielzahl von Teilsystemen innerhalb des Gesamtsystems einzelne Übertragungswege oder Hauptverbindungen gemeinsam benutzen. Bei der Auslegung solcher Systeme muß ein Kompromiß zwischen Arbeitsgeschwindigkeit und Systemflexibilität gefunden werden. Dies sei am Beispiel der in den Fig. 1, 2 und 3 dargestellten bekannten Schaltungen kurz herausgestellt. Fig. 1 zeigt eine bekannte Treiberschaltung in Emitterschaltung. Die von diesem Treiber zu treibende Last ist durch eine an den Ausgang VA angeschlossene Kapazität C angedeutet. Wird an den Eingang A ein oberer Signalpegel angelegt, so werden die Transistoren 10 und 20 leitend und am Ausgang VA erhält man einen unteren Ausgangssignalpegel. Wird dem Eingang A der untere Eingangssignalpegel zugeführt, so werden die Transistoren 10 und 20 gesperrt und am Ausgang VA erscheint der obere Ausgangssignalpegel. Der Vorteil der betrachteten Treiberschaltung liegt darin, daß mehrere von ihr dadurch logisch verknüpfbar sind, daß die Ausgänge direkt miteinander verbunden werden. Durch diese Verknüpfung erreicht man, daß der Last der niedrige Ausgangssignalpegel zugeführt wird, wenn am Ausgang irgendeiner der verknüpften Treiberschaltungen der niedrige Ausgangssignalpegel erscheint. Der dabei von anderen, sich im Schaltzustand mit hohem Ausgangssignalpegel befindlichen Treiberschaltungen gelieferte Strom kann dadurch möglichst klein gehalten werden, daß ein großer Widerstand R im Kollektorkreis des Transistors 20 vorgesehen wird. Die betrachtete Treiberschaltung hat somit den Vorteil der Verknüpfungsmöglichkeit, sie zeigt jedoch den Nachteil, daß der Übergang vom Schaltzustand mit niedrigem Ausgangssignalpegel zum hohen Ausgangssignalpegel außerordentlich langsam ist und von der RC-Zeitkonstanten bestimmt wird. In einer Vielzahl von Anwendungen ist diese Schaltung infolge der geringen Schaltgeschwindigkeit nicht brauchbar.

Eine Alternative zur Treiberschaltung nach Fig. 1 ist in Fig. 2 dargestellt. Es handelt sich um eine Gegentakt-Treiberschaltung, wie sie im »IBM Technical Disclosure Bulletin«, Vol. 21, Nr. 1, Juni 1978, Seite 172 beschrieben ist. Bei dieser Treiberschaltung wird der Übergang von der Schaltlage mit niedrigem Ausgangssignalpegel zur Schaltlage mit hohem Ausgangssignalpegel, also der Aufladevorgang, dadurch beschleunigt, daß zusätzlich ein Aufladestromkreis mit dem Transistor 16 vorgesehen ist. Bei dieser Treiberschaltung wird also gewährleistet, daß sowohl der Auflade- als auch der Entladevorgang mit hoher Geschwindigkeit erfolgt. Liegt am Eingang A der hohen Signalpegel an, dann sind die Transistoren 11 und 14 leitend und erzeugen den Schaltzustand mit dem niedrigen Ausgangssignalpegel. Liegt dagegen der niedrige Eingangssignalpegel an, so sind die Transistoren 11 und 14 gesperrt und der Transistor 16 leitend, so daß der hohe Ausgangssignalpegel erzeugt wird. Auch diese Treiberschaltung weist einen nicht zu unterschätzenden Nachteil auf. Werden nämlich mehrere von diesen Treiberschaltungen zur Bildung einer logischen Verknüpfung am Ausgang zusammengeschaltet, so können unzulässig hohe Ströme durch den Transistor 16 fließen, wenn der Entladestromkreis eines der anderen Treiberschaltungen leitend ist. Das bedeutet, daß Sperreingänge vorzusehen sind, über die der Transistor 16 auch bei Anliegen des niedrigen Eingangssignalpegels gesperrt werden kann. Führt man an den Sperreingängen einen hohen Signalpegel zu, so werden die Transistoren 12 und 18 leitend und die Transistoren 14 und 16 gleichzeitig gesperrt. In dieser Situation übernimmt eine der anderen Treiberschaltungen die Steuerung des Ausgangssignalpegels. Der für diese Sperrmaßnahme und die dafür zusätzlich erforderliche Steuerlogik erforderliche Aufwand ist beträchtlich. Außerdem wird die Zuverlässigkeit der Treiberschaltung herabgesetzt.

Eine dritte, ebenfalls im »IBM Technical Disclosure Bulletin«, Vol. 21, Nr. 1, Juni 1978 auf den Seiten 233 und 234 veröffentlichte Gegentakt-Treiberschaltung ist in Fig. 3 dargestellt. In dieser Schaltung bildet der Transistor 22 den Aufladestromkreis und der Transistor 24 den Entladestromkreis für Schaltvorgänge in beiden Schaltrichtungen. Ein Transistor 26 gewährleistet die Eigenschaft der ausgangsseitigen Verknüpfung mehrerer solcher Gegentakt-Treiberschaltungen. Liegt am Eingang A der obere Eingangssignalpegel an, so ist der Transistor 24 leitend, und am Ausgang VA liegt ein Pegel, der niedriger ist als eine Bezugsspannung Vref. Das bedeutet, daß der Transistor 26 leitend wird und damit den Transistor 22 sperrt. Sieht man einen sehr großen Widerstand 28 im Kollektorkreis des Transistors 24 vor, so kann der in diesem Schaltzustand gezogene Strom auf einem niedrigen Wert gehalten werden. Wird am Eingang A vom oberen auf den unteren Signalpegel umgeschaltet, so wird der Transistor 24 gesperrt und der Ausgangssignalpegel steigt mit einer durch die RC-Zeitkonstante des Widerstandes 28 und der kapazitiven Last C bestimmten Geschwindigkeit an. Sobald der Ausgangssignalpegel die Bezugsspannung Vref übersteigt, wird der Transistor 26 gesperrt und der Transistor 28 leitend. Der Signalpegel am Ausgang VA steigt dabei steil an und erreicht einen Wert von $V - V_{be}$, wobei V die Betriebsspannung der Treiberschaltung und $V_{be}$ die Basis-Emitterspannung des Transistors 22 darstellt. In diesem Zeitpunkt wird der Transistor 22 gesperrt und der Ausgangssignalpegel steigt nunmehr mit der RC-Zeitkonstanten auf den Wert der Betriebsspannung V an.

Wird eine weitere derartige Treiberschaltung ausgangsseitig angekoppelt, so bleibt die Arbeitsweise der Treiberschaltung nach Fig. 3 im wesentlichen gleich. Das heißt, liegt am Ausgang VA der hohe Ausgangssignalpegel, so kann der den Entladestromkreis bildende Transistor 30 der weiteren Treiberschaltung in den leitenden Zustand geschaltet werden. Dabei wird die kapazitive Last entladen, was dazu führt, daß der Transistor 26 leitend und infolge davon, der Transistor 22 gesperrt wird.

Die bekannte Treiberschaltung nach Fig. 3 hat sich zwar in vielen Anwendungen als nützlich erwiesen, sie ist für viele andere Anwendungen aber auch weniger brauchbar, da der Aufladevorgang, d. h. also, der Anstieg des Ausgangsspannungspegels am Anfang und Ende des entsprechenden Schaltvorganges zu langsam verläuft. Als sehr ernstes Problem hat sich herausgestellt, daß die Funktionstüchtigkeit dieser Treiberschaltung nicht in jedem Falle sichergestellt ist, wenn nicht gewisse zusätzliche Sicherheitsvorkehrungen getroffen werden, die wiederum die Funktion der Treiberschaltung behindern können. Beispielsweise hängt die funktionsgerechte Arbeitsweise des Transistors 26 davon ab, daß der Ausgangssignalpegel unter die Bezugsspannung Vref abfällt. Die Bezugsspannung liegt typischerweise bei etwa 1 V, während die Betriebsspannung V etwa bei 3 V angenommen werden kann. Der obere Ausgangssignalpegel beträgt etwa 3 V. Wird der Transistor eines Entladestromkreises in den leitenden Zustand gebracht, so nimmt der Ausgangssignalpegel anfänglich ab und es wird über Transistor 22 ein Strom geliefert. Die Funktionstüchtigkeit der Treiberschaltung nach Fig. 3 hängt davon ab, ob über den Transistor des Entladestromkreises ein Strom schneller von der kapazitiven Last abgeführt werden kann, als ein Strom über den Transistor 22 zugeführt wird. Sollte diese Bedingung nicht eingehalten werden, so kann der Ausgangssignalpegel die Bezugsspannung Vref nicht unterschreiten. Dieses Problem mag bei einer einzelnen Gegentakt-Treiberschaltung zwar nicht auftreten, sind aber mehrere solcher Treiberschaltungen ausgangsseitig gekoppelt, so sind entsprechend mehrere Transistoren 22 vorhanden, die parallel Strom zuführen können. Die Wahrscheinlichkeit, daß der Ausgangssignalpegel die Bezugsspannung unterschreiten kann, ist damit offensichtlich sehr zweifelhaft.

Aus der Veröffentlichung »IBM Technical Disclosure Bulletin«, Band 18, Nr. 11, April 1976, Seite 3651 ist bereits eine Gegentakt-Treiberschaltung gemäß dem 1. Teil des Anspruchs 1 bekannt. Dabei ist der Eingang der Treiberschaltung über ein eine Koppelkapazität enthaltendes Zeitglied mit dem Steuereingang des Aufladestromkreises verbunden, so daß der Aufladestromkreis nur während der Umladezeit der Kapazität leitend ist und den gewünschten Ausgangssignalpegel erzeugt.

Zwar ist bei dieser Treiberschaltung die ausgangsseitig direkte logische Verknüpfungbarkeit gegeben, diese Schaltung hat jedoch zumindest den Nachteil, daß die im wesentlichen von der Zeitkonstanten des Zeitgliedes bestimmte Dauer des Leitzustandes des Aufladestromkreises nicht exakt definiert und insbesondere nicht den jeweiligen Betriebsbedingungen angepaßt ist.

Hier will die Erfindung Abhilfe schaffen. Die Erfindung, wie sie in den Ansprüchen gekennzeichnet ist, löst die Aufgabe, eine Treiberschaltung anzugeben, die ausgangsseitig direkt mit weiteren entsprechenden Treiberschaltungen logisch verknüpfbar ist, die Schaltgeschwindigkeit von Gegentakt-Treiberschaltung aufweist und bei relativ geringem Aufwand größtmögliche Zuverlässigkeit gewährleistet.

Zusammengefaßt kann die Erfindung folgendermaßen dargestellt werden. Bei einer Gegentakt-Treiberschaltung ist zusätzlich eine Sperrschaltung vorgesehen, die zuläßt, daß der Aufladestromkreis während eines Aufladevorganges große Ströme liefern kann, im Ruhezustand jedoch den Strom in diesem Aufladestromkreis stark begrenzt. Unter Umständen zur Zerstörung führende Ströme durch den Aufladestromkreis bei der ausgangsseitigen Zusammenschaltung mehrerer solcher Treiberschaltungen werden dadurch verhindert, daß eine Begrenzung dieses Stromes bewirkt wird, bevor einer der Entladestromkreise leitend wird. Auf diese Weise erzielt man extrem schnelle Schaltvorgänge in beiden Schaltrichtungen, geringe Ruheströme und vermeidet insbesondere enorm hohe Kurzschlußströme durch den Aufladestromkreis beim Einschalten eines Entladestromkreises.

Im folgenden wird die Erfindung anhand der Zeichnung näher erläutert. Es zeigt

Fig. 1 das Schaltbild der eingangs beschriebenen bekannten Treiberschaltung in Emitterschaltung,

Fig. 2 das Schaltbild der eingangs beschriebenen bekannten, drei Betriebszustände aufweisenden Gegentakt-Treiberschaltung,

Fig. 3 das Schaltbild der eingangs beschriebenen bekannten Gegentakt-Treiberschaltung, die ausgangsseitig direkt logisch verknüpfbar ist,

Fig. 4 das Schaltbild einer erfindungsgemäßen Gegentakt-Treiberschaltung und

Fig. 5 eine abgewandelte Version der erfindungsgemäßen Gegentakt-Treiberschaltung nach Fig. 4.

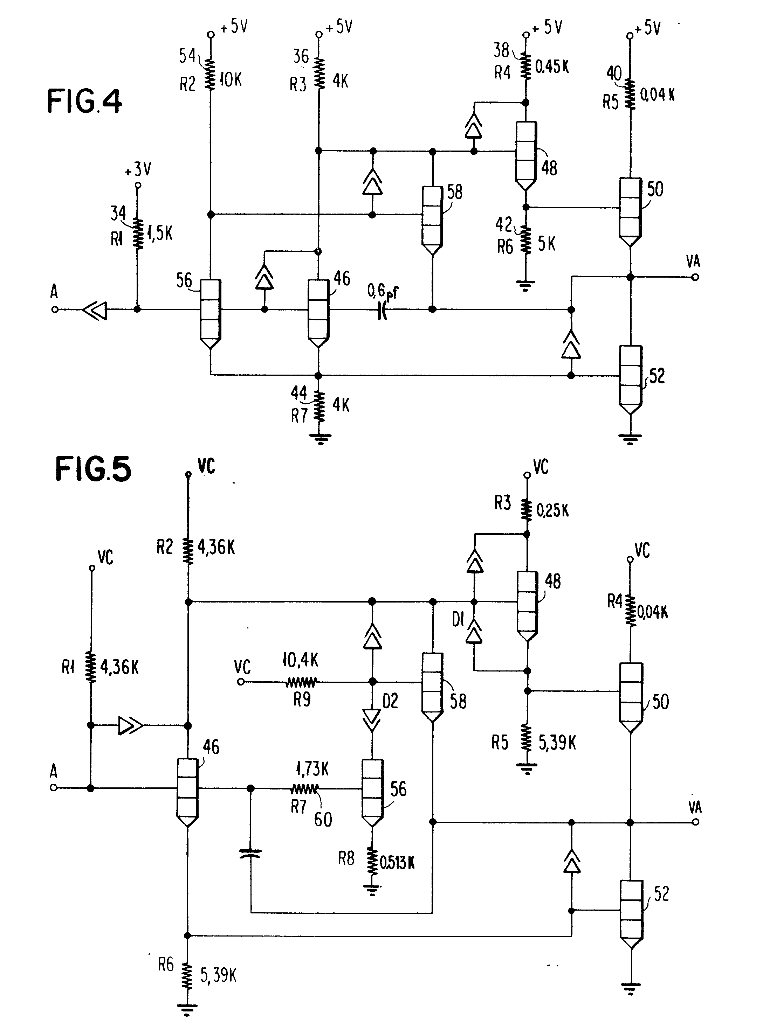

Die Erfindung wird im folgenden anhand der in der Fig. 4 dargestellten Gegentakt-Treiberschaltung beschrieben.

Die in Fig. 4 dargestellte Treiberschaltung, in der die Widerstände 34 bis 44 und die Transistoren 46 bis 52 eine Gegentakt-Treiberschaltung in üblicher Ausführung bilden, dient zum Treiben kapazitiver Lasten. Wird an den Eingang A ein den oberen Pegel aufweisendes Eingangssignal angelegt, so werden die Transistoren 46 und 52 leitend und die Transistoren 48 und 50 gesperrt. Am Ausgang VA erhält man ein Ausgangssignal mit dem unteren Signalpegel. Legt man an den Eingang A ein Eingangssignal mit dem unteren Signalpegel, so werden die Transistoren 46 und 52 gesperrt, während die Transistoren 48 und 50 leitend sind. Am Ausgang VA erhält man ein Ausgangssignal mit dem oberen Signalpegel. Der Transistor 52 wirkt also als Schalter, der am Treiberausgang den unteren Signalpegel liefert. Die Transistoren 48 und 50 wirken als Schalter, der an den Treiberausgang den oberen Signalpegel hervorruft. Der Transistor 46 wirkt als Echt-Komplement-Generator, der den beiden zuvor genannten Schaltern um 180° phasenverschobene Steuersignale zuführt. Die bisher beschriebene Schaltung und ihre Wirkungsweise sind allgemein bekannt.

Die erfindungsgemäße Schaltung unterscheidet sich von der beschriebenen bekannten Schaltung dadurch, daß ein Widerstand 54 und Transistoren 56 und 58 zusätzlich vorgesehen sind. Diese zusätzlichen Schaltelemente begrenzen den Strom des Transistors 50 während des Betriebes der Schaltung im Ruhestand und sie verhindern unzulässig hohe Ströme in diesem Widerstand, wenn der Ausgang VA der Treiberschaltung über den entsprechenden Ausgang einer weiteren, daran angeschlossenen Treiberschaltung auf den unteren Ausgangssignalpegel abgesenkt wird. Die Wirkungsweise der Treiberschaltung nach Fig. 4 sei nunmehr unter Einschluß der zusätzlichen Schaltelemente beschrieben.

Wird an den Eingang A der obere Signalpegel angelegt, so werden die Transistoren 56, 46 und 52 leitend, während die Transistoren 58, 48 und 50 gesperrt werden. Am Ausgang VA wird der untere Ausgangssignalpegel geliefert. In diesem Zustand wird der Transistor 56 in Sättigung betrieben. Wird der Eingang vom oberen zum unteren Signalpegel umgeschaltet, so werden die Transistoren 56, 46 und 52 gesperrt und die Transistoren 48 und 50 leitend. Dabei wird eine Stromspitze erzeugt, durch die der Pegel des Ausgangssignals angehoben wird. Da der Transistor 56 in Sättigung leitend war, wird er an seinem Kollektor während einer kurzen Zeitdauer nach dem Umschalten des Eingangspegels nicht abgeschaltet. Damit bleibt während dieser kurzen Zeitdauer die Spannung an der Basis des Transistors 58 niedrig. Die auftretende Verzögerung bestimmt sich aus dem Grade der Sättigung, die mit Hilfe des Widerstandes 34 eingestellt wird, und aus der RC-Zeitkonstanten, die durch den mit der Basis des Transistors 58 verbundenen Widerstand 54 festgelegt wird. Das bedeutet also, daß der Transistor 58 gesperrt bleibt, während der Ausgangssignalpegel ansteigen kann. Sobald der Transistor 56 aus der Sättigung kommt, steigt die Spannung an der Basis des Transistors 58 an und bringt den Transistor 58 in den leitenden Zustand. Dadurch wird die Spannung an der Basis des Transistors 48 abgesenkt. Die Transistoren 48 und 50 werden damit gesperrt, aber der Ausgangssignalpegel ist bereits über den Schwellwert angehoben, der ihn als Information am Ausgang erkennbar macht. Es sei nunmehr die Funktion der erfindungsgemäßen Schaltung nach Fig. 4 beschrieben, wenn mehrere solcher Schaltungen ausgangsseitig direkt logisch verknüpft werden. Im Ruhezustand, bei dem der obere Ausgangssignalpegel geliefert wird, sind die Transistoren 48 und 50 gesperrt, so daß lediglich ein Strom von vielleicht 0,4 mA über Transistor 58 geliefert wird. Wird der Entladetransistor einer anderen, mit der Schaltung nach Fig. 4 ausgangsseitig verknüpften Gegentakt-Treiberschaltung in den leitenden Zustand gebracht, so daß der Ausgangssignalpegel abgesenkt wird, wobei von der Treiberschaltung nach Fig. 4 lediglich vom Transistor 58 ein Strom von etwa 1,5 mA geliefert wird. Der Transistor bleibt gesperrt, so daß störende Ströme verhindert werden. Befände sich die Treiberschaltung nach Fig. 4 jedoch in einem Ruhezustand, bei dem der Transistor 52 leitend ist und am Ausgang der untere Signalpegel anliegt, so ergäbe das gleichzeitige Schalten einer der ausgangsseitig angeschlossenen Treiberschaltungen in den oberen Ausgangssignalpegel einen hohen Strom (etwa 40 mA) im Transistor 50 der angeschlossenen Treiberschaltung. Dieser Strom würde jedoch höchstens einige ns fließen, bis der Transistor 56 der anderen Treiberschaltung aus der Sättigung gebracht ist.

Die Vorteile der Gegentakt-Treiberschaltung nach der Erfindung liegen darin, daß eine große Anzahl solcher Schaltungen ausgangsseitig logisch verknüpfbar ist, daß in beiden Schaltrichtungen hohe Schaltgeschwindigkeiten erzielt werden und daß keine komplizierte, drei Schaltzustände umfassende logische Steuerschaltung erforderlich ist. Außerdem ist für den Fall eines logischen Fehlers dafür gesorgt, daß keine unzulässig hohen Ströme fließen, da auch im Ruhezustand der Aufladetransistor 50 gesperrt bleibt.

Die erfindungsgemäße Treiberschaltung nach Fig. 5 entspricht im wesentlichen der in Fig. 4 dargestellten Treiberschaltung. Die Lage der Transistoren 46 und 56 im Schaltbild ist vertauscht, die elektrischen Verbindungen sind jedoch gleichgeblieben. Verändert sind die Werte der verwendeten Widerstände. Zusätzlich eingefügt wurde eine Schottky-Diode D1 zwischen Emitter und Basis des Transistors 48 ebenso wie eine Diode D2, die den Transistor 56 vor unter Umständen am Ausgang der Treiberschaltung auftretenden hohen negativen Spannungen schützen soll. Die Wirkungsweise selbst der Treiberschaltung nach Fig. 5 entspricht der der Schaltung nach Fig. 4.

**Pantentansprüche**

1. Gegentakt-Treiberschaltung, die mit entsprechenden weiteren Treiberschaltungen durch direkte elektrische Verbindung der Ausgänge logisch verknüpfbar ist, deren Eingang (A) mit den komplementär gesteuerten Steuereingängen eines Aufladestromkreises (48, 50) und eines Entladestromkreises (52) gekoppelt ist, deren Ausgang (VA) aus den beiden verbundenen Ausgängen des Auflade- und Entladestromkreises besteht, und bei der der Aufladestromkreis (50) nach einer Verzögerung gesperrt wird, deren Dauer ausreicht, daß der Ausgangssignalpegel der Treiberschaltung einen vorbestimmten Wert erreicht, dadurch gekennzeichnet, daß an den Steuereingang des Aufladestromkreises (50) eine Sperrschaltung (58) für diesen angeschlossen ist, die über eine Verzögerungsstufe (56) mit dem Ausgangs (VA) der Treiberschaltung verbunden ist und das Ansprechen der Sperrschaltung (58) solange unterbindet, bis der Ausgangssignalpegel den vorbestimmten Wert erreicht hat.

2. Gegentakt-Treiberschaltung nach Anspruch 1, dadurch gekennzeichnet, daß die Sperrschaltung einen die Spannung am Steuereingang des Aufladestromkreises (48, 50) begrenzenden Transistor (58) enthält.

3. Gegentakt-Treiberschaltung nach Anspruch 1 oder 2, dadurch gekennzeichnet, daß die Verzögerungsstufe einen Transistor (56) umfaßt, der bei im Ruhezustand der Treiberschaltung unterem Ausgangssignalpegel in Sättigung leitend ist und erst bei Erreichen des vorbestimmten Wertes des Ausgangssignalpegels aus der Sättigung gelangt.

4. Gegentakt-Treiberschaltung nach den Ansprüchen 1 bis 3, dadurch gekennzeichnet, daß der Auf- und Entladestromkreis jeweils einen Transistor (50, 52) enthält und daß die Sperrschaltung aus einem Transistor (58) besteht, bei dem ein Eingangsanschluß mit dem Steuereingang des Aufladestromkreises (48, 50), ein Ausgangsanschluß mit dem Ausgang (VA) der Treiberschaltung und ein Steueranschluß mit dem Ausgang der Verzögerungsstufe (56) gekoppelt ist.

5. Gegentakt-Treiberschaltung nach Anspruch 4, dadurch gekennzeichnet, daß die Verzögerungsstufe einen Transistor (56) umfaßt, bei dem der Steueranschluß mit dem Eingang (A) der Treiberschaltung gekoppelt ist.

**Claims**

1. Push-pull driver circuit that is logically linkable to corresponding further driver circuits by electrically connecting the outputs, the input (A) being coupled to the complementarily controlled control inputs of a charge circuit (48, 50) and of a discharge circuit (52), whose output (VA) consists of the two connected outputs of the charge and discharge circuit, and where the charge circuit (50) is deactivated after a delay that is long enough for the output signal level of the driver circuit to reach a predetermined value, characterized in that at the control input of the charging circuit (50) a disabling circuit (58) for the latter is provided which via a delay stage (56) is connected to the output (VA) of the driver circuit and prevents the responding of the disabling circuit (58) until the output signal level has reached the predetermined value.

2. Push-pull driver circuit as claimed in claim 1, characterized in that the disabling circuit comprises transistor (58) limiting the voltage et the control input of the charging circuit (48, 50).

3. Push-pull diver circuit as claimed in any one of claim 1 or 2, characterized in that the delay stage comprises a transistor (56) which operates in saturation during steady-state driver operation with a low level output signal, and which comes out of saturation only after the predetermined value has reached the output signal level.

4. Push-pull driver circuit as claimed in any one of claims 1 to 3, characterized in that the charge and discharge circuit each comprises a transistor (50, 52), and that the disabling circuit consists of a transistor (58) where an input connection is coupled to the control input of the charging circuit (48, 50), an output connection to the output (VA) of the driver circuit, and a control connection to the output of the delay stage (56).

5. Push-pull driver circuit as claimed in claim 4, characterized in that the delay stage comprises a transistor (56) where the control input is coupled to the input (A) of the driver circuit.

**Revendications**

1. Amplificateur d'attaque symétrique, qui peut étre relié logiquement à d'autres amplificateurs d'attaque correspondants par une liaison électrique directe des sorties, dont l'entrée (A) est couplée aux entrées de commande commandées complémentairement d'un circuit de charge (48, 50) et d'un circuit de décharge (52), dont la sortie (VA) est constituée par les deux sorties connectées des circuits de charge et de décharge et dans lequel le circuit de charge (50) se bloque après une temporisation, dont la durée suffit pour que le niveau de signal de sortie de l'amplificateur d'attaque atteigne une valeur prédéterminée, caractérisé en ce qu'à l'entrée de commande du circuit de charge (50) est branché un circuit de blocage (58), pour celui-ci, circuit relié par l'intermédiaire d'un étage de temporisation (56) à la sortie (VA) de l'amplificateur d'attaque et empêchant le déclenchement du circuit de blocage (58) jusqu'à ce que le niveau de signal de sortie atteigne la valeur fixée à l'avance.

2. Amplificateur d'attaque symétrique suivant la revendication 1, caractérisé en ce que le circuit de blocage contient un transistor (58) limitant la tension à l'entrée de commande du circuit de charge (48, 50).

3. Amplificateur d'attaque symétrique suivant l'une quelconque des revendications 1 et 2, caractérisé en ce que l'étage de temporisation comprend un transistor (56), qui est passant en saturation avec un niveau inférieur de signal de sortie, lorsque l'amplificateur d'attaque est dans l'état de repos, et qui perd sa saturation seulement quant la valeur prédéterminée du niveau de signal de sortie est atteinte.

4. Amplificateur d'attaque symétrique suivant l'une quelconque des revendications 1 à 3, caractérisé en ce que le circuit de charge et le circuit de décharge contiennent chacun un transistor (50, 52) et que le circuit de blocage est constitué par un transistor (58), sur lequel une connexion d'entrée est couplée à l'entrée de commande dur circuit de charge (48, 50), une connexion de sortie est couplée à la sortie (VA) de l'amplificateur d'attaque et une connexion de commande est couplée à la sortie de l'étage de temporisation (56).

5. Amplificateur d'attaque symétrique suivant la revendication 4, caractérisé en ce que l'étage de temporisation comprend un transistor (56), sur lequel la connexion de commande est couplée à l'entrée (A) de l'amplificateur d'attaque.

FIG. 1

FIG. 2

SIGNAL-
EINGANG    A

R1

SPERR-
EINGÄNGE

AUSGANG

R2

R3

R5

R4

-V

FIG. 3

V

Rv      r      R
        32     28

22

Vref

26

VA

A

24

C

30

FIG.4

FIG.5